# DEMANDE DE BREVET EUROPEEN

(11) **EP 1 037 390 A1**
(43) Date de publication de la demande: **20.09.2000**
(21) Numéro de dépôt: 00400715.9
(22) Date de dépôt: 15.03.2000
(51) Int. Cl.: H03M 7/30, G10L 19/02

(54) **Procédé de codage, de décodage et de transcodage**

(30) Priorité: 17.03.1999 FR 9903314
(71) Demandeur: Matra Nortel Communications, 29100 Quimper (FR)
(72) Inventeur: Murgia, Carlo, IRVINE, CA 92618 (US); Richard, Gael, 78140 Velizy (FR); Lockwood, Philip, 95490 Vaureal (FR)
(74) Mandataire: Verdure, Stéphane

(57) **Abrégé**

Sur la base d'une portion du signal, un codeur sélectionne un vecteur de paramètres appartenant à un dictionnaire de référence contenant 2^{*Q*} vecteurs désignés chacun par une adresse de *Q* bits. Ce codeur, ou un transcodeur situé en aval, forme un flux binaire (Φ) contenant un indice déduit de l'adresse du vecteur sélectionné. Pour chaque valeur de débit correspondant à un entier *p*≥0, l'indice contenu dans le flux binaire est formé de *Q-p* bits qui, complétés par *p* bits de positions prédéterminées, définissent des indices de *Q* bits représentant un groupe de 2^{*p*} adresses incluant celle du vecteur sélectionné dans le dictionnaire de référence. Le décodeur recevant le flux binaire, ou un transcodeur situé en amont, est capable de reconstruire des vecteurs de paramètres appropriés sur la base de l'indice tronqué. On obtient ainsi une très fine granularité dans le réglage du débit de transmission.

## Description

La présente invention concerne le codage de signaux numériques, et plus particulièrement les procédés de codage, de décodage et éventuellement de transcodage faisant appel à une quantification vectorielle.

La quantification vectorielle est couramment employée dans divers procédés de codage. Dans la suite de la présente description, on s'intéressa plus particulièrement au codage des signaux audio, sans que ceci soit limitatif.

L'invention se pose le problème de l'échelonnabilité (« scalability ») du flux binaire transmis entre un codeur et un décodeur. Cette propriété consiste en la capacité du codeur de construire des flux de sortie de débit variable à partir d'un même schéma de codage appliqué au signal numérique codé, et en la capacité correspondante du décodeur de reconstruire une version fidèle du signal.

La difficulté est ici, sans augmenter outre mesure la complexité des circuits employés, de procurer une qualité de codage la plus grande possible pour chaque valeur de débit.

L'échelonnabilité du flux présente une importance particulière dans le cas où le flux est susceptible d'être transporté sur des réseaux à commutation de paquets, tels que des réseaux opérant suivant le protocole IP (« Internet Protocol »). Historiquement, la plupart des codeurs ont été développés pour des applications de diffusion ou de communication en mode circuit, conduisant à des codeurs à débit fixe, ou à débit sélectionné parmi plusieurs valeurs possibles à l'établissement de la connexion. Dans le contexte du mode paquets, il convient que le débit varie plus dynamiquement, afin de pouvoir adapter le flux aux encombrements rencontrés dans le transport des paquets tout en garantissant le maintien de la communication.

La demande de brevet WO99/03210 décrit un codeur audio à flux échelonnable, ayant plusieurs étages de codage. Le premier étage comporte un noyau codeur, pouvant être un codeur normalisé de type CELP (« Code-Excited Linear Prediction) ou autre, et éventuellement un banc de filtres de décomposition en sous-bandes et des modules complémentaires de quantification de sous-bandes plus élevées que celle traitée par le noyau codeur. Le second étage comporte un autre banc de filtres de décomposition en sous-bandes du signal d'erreur résiduelle en sortie du noyau codeur, des modules de quantification des composantes issues de cette décomposition en sous-bandes, et éventuellement des modules complémentaires de quantification des signaux d'erreur résiduelle en sortie des modules de quantification des sous-bandes plus élevées du premier étage. Les signaux d'erreur résiduelle en sortie du second étage peuvent ensuite être traités par un troisième étage, etc. Le flux binaire de sortie de ce codeur est échelonnable en jouant sur le nombre de modules de codage/quantification qui y contribuent. Pour le débit le plus bas, seul le noyau codeur intervient. Pour faire augmenter le débit, on ajoute des composantes et/ou des étages de quantification des erreurs résiduelles.

Le brevet US 5,864,650 divulgue un procédé de génération d'un dictionnaire de type arborescent contenant 2^{L} vecteurs obtenus par des sommes algébriques de L vecteurs de base. Du côté du codeur, la recherche du vecteur codant une valeur déterminée d'un signal à transmettre, procède par sélections successives de la racine vers les feuilles de l'arbre de codes, en l'arrêtant à l'étage de l'arbre de codes correspondant au nombre de bits de quantification disponibles. Un tel dictionnaire est toutefois très contraint et ne permet pas une bonne qualité de codage.

Le brevet US 4,899,384 divulgue un procédé d'allocation de bits dans le cadre d'un codage en sous-bandes, laquelle allocation tient compte du niveau et de la distribution d'énergie dans la bande et dans chaque sous-bande, de manière à respecter une contrainte globale de débit tout en dénaturant au minimum le signal transmis. Toutefois, la quantification envisagée dans ce document est une quantification scalaire et non une quantification vectorielle.

Un but principal de la présente invention est d'obtenir une fine granularité de débit dans l'échelonnabilité du flux binaire, permettant de rechercher le meilleur compromis débit/qualité en fonction des conditions de communication.

Un premier aspect de l'invention se rapporte ainsi à un procédé de codage d'un signal, dans lequel on sélectionne, sur la base d'une portion du signal, au moins un vecteur de paramètres de codage appartenant à un dictionnaire de référence contenant 2^{*Q*} vecteurs désignés chacun par une adresse de *Q* bits, et on forme un flux binaire de sortie contenant un indice déduit de l'adresse du vecteur sélectionné dans le dictionnaire de référence. Selon ce procédé, le flux binaire de sortie a un débit réglable en jouant sur le nombre *Q-p* de bits formant ledit indice contenu dans le flux binaire. Pour chaque valeur de débit correspondant à une valeur de l'entier *p*≥0, l'indice contenu dans le flux binaire est formé de *Q-p* bits qui, complétés par p bits arbitraires de positions prédéterminées, définissent des indices de *Q* bits représentant un groupe de 2^{*p*} adresses incluant l'adresse du vecteur sélectionné dans le dictionnaire de référence.

Une réduction de débit du codeur résulte de la suppression de *p* bits de certains indices de quantification vectorielle. En faisant varier ce nombre *p*, on est capable de réaliser une grande finesse d'échelonnabilité du flux binaire de sortie.

Afin de minimiser l'impact de la réduction du débit sur la qualité du signal que le décodeur est capable de reconstruire, les *p* bits supprimés seront généralement les moins significatifs de l'indice concerné.

On peut alors prévoir que, pour au moins une valeur de débit correspondant à une valeur de l'entier *p*>0, le dictionnaire de référence soit ordonné de façon à vérifier un critère de distances minimales entre les vecteurs appartenant à chaque groupe de 2^{*p*} vecteurs du dictionnaire de référence dont les adresses respectives ne diffèrent que par les *p* bits ayant lesdites positions prédéterminées.

Une autre possibilité est de consulter une table de transcodage sur la base de l'adresse du vecteur sélectionné dans le dictionnaire de référence pour obtenir un premier indice de *Q* bits. Pour chaque valeur de débit correspondant à une valeur de l'entier *p*≥0, l'indice contenu dans le flux binaire de sortie est alors formé de *Q-p* bits extraits dudit premier indice de *Q* bits en excluant *p* bits de positions prédéterminées.

Cette dernière possibilité est intéressante en ce qu'elle permet d'adapter un codeur existant, optimisé selon d'autres critères, au concept d'échelonnabilité, la table de transcodage permettant de limiter la dégradation de qualité due à la suppression de certains bits. Dans ces conditions le codeur peut avoir un premier mode de fonctionnement dans lequel, pour chaque valeur de débit correspondant à une valeur de l'entier *p*≥0, l'indice contenu dans le flux binaire de sortie est formé des *Q-p* bits extraits dudit premier indice de *Q* bits, et un second mode de fonctionnement à débit défini dans lequel l'adresse du vecteur sélectionné dans le dictionnaire de référence est incluse dans le flux binaire de sortie au lieu dudit indice de formé *Q-p* bits. L'un ou l'autre des deux modes sera choisi selon les capacités du décodeur recevant le flux et/ou selon le moyen utilisé pour transporter le flux jusqu'à ce décodeur.

Un second aspect de l'invention se rapporte à un procédé de décodage d'un flux binaire représentatif d'un signal codé, le flux binaire contenant, pour une portion du signal, au moins un indice permettant d'obtenir, au moyen d'un dictionnaire de référence contenant 2^{*Q*} vecteurs désignés chacun par une adresse de *Q* bits, un vecteur de paramètres de codage utilisé pour construire une version décodée de ladite portion de signal. Dans ce procédé de décodage, le débit du flux binaire dépend du nombre *Q-p* de bits formant ledit indice. Pour chaque valeur de débit correspondant à une valeur de l'entier *p*≥0, on obtient le vecteur de paramètres de codage à partir d'au moins un vecteur du dictionnaire de référence dont l'adresse appartient à un groupe de 2^{*p*} adresses respectivement représentées par des indices de *Q* bits formés en complétant par *p* bits arbitraires de positions prédéterminées l'indice de *Q-p* bits contenu dans le flux binaire.

Plusieurs méthodes peuvent être appliquées pour obtenir le vecteur de paramètres de codage à partir de l'indice de *Q-p* bits quand *p*≥0.

Le procédé de décodage peut ainsi comprendre un mode de fonctionnement par sélection de vecteur dans lequel, pour au moins une valeur de débit correspondant à une valeur de l'entier *p*>0, on obtient le vecteur de paramètres de codage en sélectionnant dans le dictionnaire de référence un vecteur dont l'adresse appartient audit groupe de 2^{*p*} adresses.

Dans ce mode, les *p* bits complétant les *Q-p* bits de l'indice contenu dans le flux binaire pour représenter l'adresse du vecteur sélectionné peuvent être des bits de valeurs prédéterminées. Ceci convient si le codeur a procédé à la quantification vectorielle en utilisant un sous-dictionnaire de cardinal 2^{*Q-p*} constitué par les vecteurs du dictionnaire de référence dont les adresses sont représentées par des indices ayant lesdites valeurs prédéterminées pour les *p* bits manquants.

Ces *p* bits peuvent encore être tirés au hasard. Ceci convient si les grandeurs quantifiées vectoriellement par les 2^{*p*} vecteurs dont les adresses appartiennent au groupe ont une distribution statistique relativement uniforme.

Dans une autre version du mode de fonctionnement par sélection de vecteur, on obtient le vecteur de paramètres de codage en le sélectionnant, parmi les vecteurs du dictionnaire de référence dont les adresses respectives appartiennent audit groupe de 2^{*p*} adresses, sur la base d'une information sur le signal codé, qui peut être lue dans le flux binaire ou encore obtenue par une analyse de la version décodée du signal.

En variante, ou en complément, le procédé de décodage peut comprendre un mode de fonctionnement par moyennage de vecteurs dans lequel, pour au moins une valeur de débit correspondant à une valeur de l'entier *p*>0, on obtient le vecteur de paramètres de codage en faisant une moyenne de plusieurs vecteurs du dictionnaire de référence dont les adresses respectives appartiennent audit groupe de 2^{*p*} adresses.

La moyenne faite pour obtenir le vecteur de paramètres de codage peut être une moyenne uniforme des vecteurs du dictionnaire de référence dont les adresses respectives appartiennent audit groupe de 2^{*p*} adresses. Ceci convient si les grandeurs quantifiées vectoriellement par les 2^{*p*} vecteurs ont une distribution statistique relativement uniforme.

Elle peut également être une moyenne pondérée pour tenir compte d'une distribution non uniforme. Les poids utilisés peuvent être des coefficients fixes affectés aux vecteurs du dictionnaire de référence de façon représentative de leurs probabilités d'occurrence a priori. Ils peuvent encore être des coefficients variables déterminés sur la base d'une information sur le signal codé. Cette information, se rapportant par exemple à un degré de stationnarité du signal, peut être lue dans le flux binaire ou encore obtenue par une analyse de la version décodée du signal.

Dans une forme d'exécution du procédé de décodage, on consulte une table de transcodage sur la base d'au moins un desdits indices de *Q* bits formés en complétant l'indice de *Q-p* bits contenu dans le flux binaire pour obtenir au moins une des 2^{*p*} adresses dudit groupe. De façon semblable au cas du procédé de codage mentionné ci-dessus, le procédé de décodage peut alors comprendre un premier mode de fonctionnement dans lequel, pour chaque valeur de débit correspondant à une valeur de l'entier *p*≥0, le vecteur de paramètres de codage est obtenu à partir d'au moins un vecteur du dictionnaire de référence dont l'adresse est obtenue en consultant la table de transcodage, et un second mode de fonctionnement à débit défini dans lequel l'indice contenu dans le flux binaire est de *Q* bits et le vecteur de paramètres de codage est obtenu comme étant le vecteur d'adresse égale audit indice de *Q* bits dans le dictionnaire de référence.

Un troisième aspect de l'invention se rapporte à un procédé de transcodage d'un flux binaire d'entrée représentatif d'un signal codé au moyen d'au moins un dictionnaire de référence contenant 2^{*Q*} vecteurs de paramètres de codage désignés chacun par une adresse de *Q* bits, pour former un flux binaire de sortie de débit plus faible,
dans lequel le flux binaire d'entrée contient, pour une portion du signal, au moins un indice de *Q* bits qui est égal à l'adresse dans le dictionnaire de référence d'un vecteur de paramètres de codage sélectionné,
dans lequel on consulte une table de transcodage sur la base de ladite adresse du vecteur sélectionné pour obtenir un autre indice de *Q* bits,
et dans lequel, dans le flux de sortie, on remplace l'indice de *Q* bits contenu dans le flux d'entrée par un indice traduit de *Q-p* bits qui, complétés par *p* bits arbitraires de positions prédéterminées, définissent des indices de *Q* bits représentant un groupe de 2^{*p*} adresses incluant ladite adresse du vecteur sélectionné, *p* étant un entier tel que 0<*p*<*Q*, ledit indice traduit de *Q-p* bits étant formé de *Q-p* bits extraits dudit autre indice de *Q* bits en excluant p bits de positions prédéterminées.

Ce procédé de transcodage peut être mis en oeuvre dans divers contextes. Par exemple, le flux binaire d'entrée peut être lu dans une mémoire d'un serveur audio. Il peut également être reçu sur une liaison d'un réseau de télécommunications, le flux binaire de sortie étant réémis sur une autre liaison du réseau ou sur une liaison d'un autre réseau.

Un quatrième aspect de l'invention se rapporte à un procédé de transcodage d'un flux binaire d'entrée représentatif d'un signal codé au moyen d'au moins un dictionnaire de référence contenant 2^{*Q*} vecteurs désignés chacun par une adresse de *Q* bits, pour former un flux binaire de sortie de débit plus élevé, dans lequel le flux binaire d'entrée contient, pour une portion du signal, au moins un indice de *Q-p* bits qui, complétés par *p* bits arbitraires de positions prédéterminées, définissent des indices de *Q* bits représentant un groupe de 2^{*p*} adresses de vecteurs dans le dictionnaire de référence, *p* étant un entier tel que 0<*p*<*Q*, et dans lequel on détermine, à partir dudit l'indice de *Q-p* bits, un indice traduit de *Q* bits représentant l'une des adresses dudit groupe de 2^{*p*} adresses de vecteurs, et on insère cet indice traduit de *Q* bits dans le flux de sortie.

Il s'agit d'un procédé de transcodage inverse du procédé précédent. Le vecteur dont l'adresse est représentée par l'indice traduit de *Q* bits peut être sélectionné par l'une des méthodes évoquées ci-dessus pour la sélection d'un vecteur dans le procédé de décodage.

D'autres particularités et avantages de la présente invention apparaîtront dans la description ci-après d'exemples de réalisation non limitatifs, en référence aux dessins annexés, dans lesquels :
- la figure 1 est un schéma synoptique d'un exemple de codeur audio pouvant mettre en oeuvre l'invention ;
- la figure 2 est un schéma synoptique d'un décodeur associé ;
- la figure 3 est un diagramme illustrant un exemple de structure de flux que peut produire le codeur de la figure 1 ;
- la figure 4 est un diagramme illustrant la construction de dictionnaires de quantification vectorielle utilisables dans des procédés selon l'invention ;
- les figures 5 et 6 sont des schémas synoptiques d'exemples de transcodeurs selon l'invention ;
- les figures 7 et 8 sont deux schémas illustrant la mise en oeuvre de la présente invention dans un serveur audio ; et
- les figures 9 à 12 sont des schémas synoptiques partiels d'un codeur, d'un décodeur et de deux transcodeurs utilisant des tables de transcodage ;

L'invention est décrite ci-après dans son application, non limitative, au codage de signaux audio. On considère à titre d'exemple un codeur du type décrit dans la demande de brevet WO99/03210, qui permet d'illustrer plusieurs façons de mettre en oeuvre l'invention. En effet, ce codeur opère des quantifications vectorielles à plusieurs niveaux, qui se prêtent chacun au processus procurant l'échelonnabilité du flux binaire. On appréciera que l'invention est applicable à de nombreux autres types de codage audio, et plus généralement à tout codage de signal faisant appel à la quantification vectorielle.

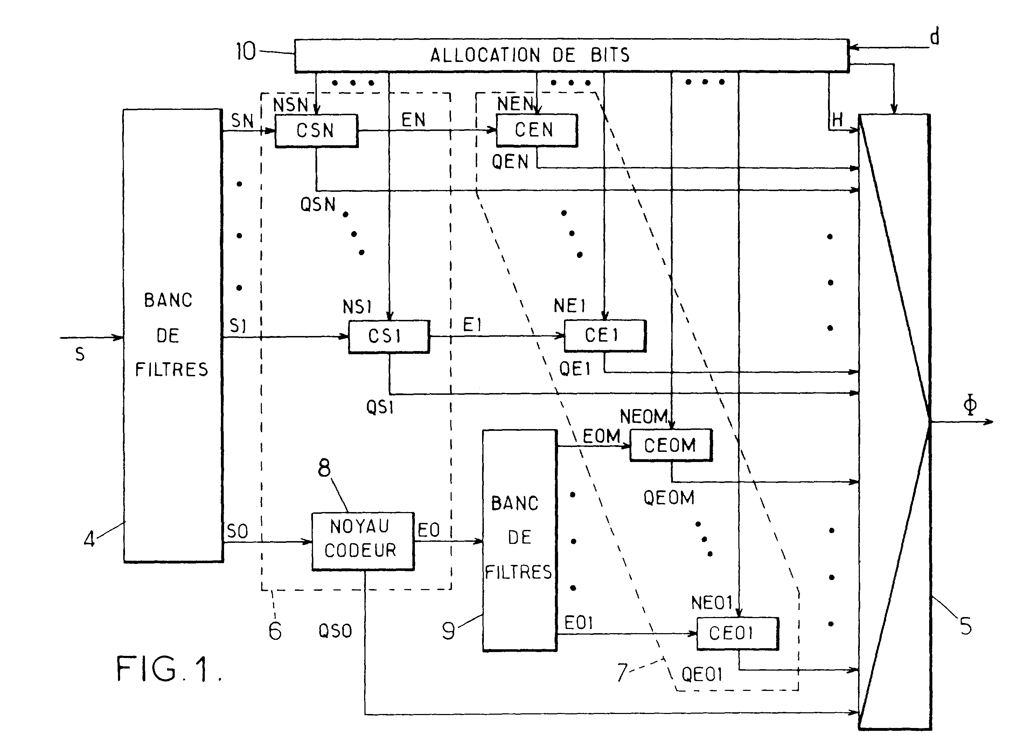

Le codeur représenté sur la figure 1 opère sur des composantes spectrales du signal audio numérique à coder S qui, dans le cas considéré, sont obtenues par décomposition en sous-bandes du signal S au moyen d'un banc de filtres 4 (dans d'autres réalisations, elles pourraient être des composantes spectrales obtenues par transformée de Fourier ou analogue).

Le signal d'entrée S est ainsi décomposé en un signal de base S0 et en un nombre N de signaux de bandes élevées S1-SN. La décomposition en sous-bandes peut être linéaire, chaque sous-bande ayant alors la même largeur spectrale, ou non linéaire. Dans ce dernier cas, les sous-bandes peuvent correspondre à l'échelle des Barks (voir E. Zwicker et al., « Psychoacoustique, l'oreille récepteur d'informations », Editions Masson, Paris, 1981). Si la bande passante du signal d'entrée ne dépasse pas 8 kHz, l'utilisation d'une échelle de Barks dans le banc de filtres 4 n'améliore pas sensiblement l'efficacité du codage, de sorte qu'on peut se dispenser de la plus grande complexité que requiert une décomposition en sous-bandes selon cette échelle.

Pour que le processus de décomposition en sous-bandes ne dégrade pas le signal d'entrée, on utilise un banc de filtres à reconstruction parfaite, constitué par exemple de filtres QMF, ou de préférence de filtres à décomposition en ondelettes de 36 coefficients.

Dans la suite de la présente description, on considérera, sans que ceci soit limitatif, que le signal de base S0 correspond à une bande de base de 0 à 4 kHz, et que les signaux de bandes élevées S1, S2, etc... correspondent aux bandes 4-5 kHz, 5-6 kHz, 6-7 kHz, 7-8 kHz, 8-10 kHz, 10-12 kHz, 12-14 kHz, 14-16 kHz, 16-20 kHz, 20-24 kHz et 24-32 kHz. Une telle croissance de la largeur de bande peut être vue comme une approximation de l'échelle des Barks qu'on peut réaliser avec un banc de filtres de complexité réduite. La liste des bandes élevées donnée ci-dessus correspond au cas où N=11 et convient pour un signal d'entrée dont la bande passante va jusqu'à 32 kHz (fréquence d'échantillonnage de 64 kHz). Pour de moins grandes bandes passantes, le nombre N est plus petit, et seules les N premières bandes de la liste ci-dessus sont utilisées.

Chacun des signaux de bandes élevées S1-SN est soumis à un module de codage respectif CS1-CSN. Chaque module de codage CSn (1≤n≤N) opère une quantification vectorielle du signal Sn qui lui est soumis. Ce signal est découpé en segments successifs formés d'échantillons numériques à une cadence d'échantillonnage moins élevée que celle du signal d'entrée S. Pour chaque segment, le codeur CSn sélectionne une forme d'onde dans un dictionnaire prédéterminé et un gain tels que le signal estimé S'n constitué par cette forme d'onde multipliée par ce gain présente un écart minimal avec le signal Sn. Cet écart constitue un signal d'erreur de quantification, noté En sur le dessin (1≤n≤N). Les méthodes de quantification vectorielle sont bien connues dans le domaine du traitement des signaux audio (voir N. Moreau : « Techniques de compression des signaux », Editions Masson, collection CNET, Paris 1995). Sur chaque fenêtre temporelle constituée par un ou plusieurs segments successifs, les formes d'onde et les gains sélectionnés sont quantifiés sur un nombre NSn de bits. Ces NSn bits forment des paramètres QSn de codage du signal Sn qui sont fournis au multiplexeur 5 formant le flux binaire Φ de sortie du codeur.

Les modules de codage CSn font partie d'un premier étage de codage 6. Le codeur de la figure 1 comporte un second étage de codage 7 incluant N modules CE1-CEN de quantification vectorielle des signaux d'erreur E1-EN respectivement délivrés par les modules CS1-CSn du premier étage. Chaque module CEn (1≤n≤N) procède à la quantification vectorielle du signal d'erreur En pour produire des paramètres de codage QEn, représentés par NEn bits sur chaque fenêtre, et qui sont fournis au multiplexeur de sortie 5.

Pour le codage du signal de base S0, le premier étage 6 comporte un noyau codeur 8 constitué par un codeur normalisé. Des exemples de codeurs normalisés utilisables sont le codeur G.723 (voir « Dual Rate Speech Coder for Multimedia Communication Transmitting at 5.3 and 6.3 kbit/s », Recommandation ITU-T G.723.1, Mars 1996), et le codeur TETRA (voir « Radio Equipment and Systems (RES), Trans-European Trunked Radio (TETRA), Speech codec for full-rate traffic channel, Part 2 : TETRA codec », Recommandation ETSI, Del ETS 300 395-2, 6 Décembre 1996). Ces exemples de codeurs sont des codeurs de parole à analyse par synthèse, c'est-à-dire qu'ils procèdent en minimisant un signal d'erreur E0 égal à la différence entre le signal S0 fourni au noyau codeur et un signal synthétique S'0 construit à partir des paramètres de codage QS0 sélectionnés. Ces paramètres QS0 sont fournis au multiplexeur de sortie 5.

Le signal d'erreur E0 est également disponible en sortie du noyau codeur 8. Ce signal d'erreur est soumis à un autre banc de filtres 9 à décomposition en sous-bandes.

Le banc de filtres 9 est de même nature que le banc de filtres 4. Il opère une décomposition linéaire du signal E0 en M sous-bandes. Le nombre M est par exemple égal à 8, ce qui donne, dans l'exemple précédemment considéré où le signal de base S0 est dans la bande 0-4 kHz, des sous-bandes de largeur 0,5 kHz (échantillonnage à 1 kHz) en sortie du banc de filtres 9.

Les M composantes spectrales du signal d'erreur E0 fournies par le banc de filtres 9 sont notées E01 à E0M. Chacune de ces composantes E0m (1≤m≤M) est soumise à un module de codage respectif CE0m appartenant au second étage 7 du codeur. Ces modules CE0m opèrent par quantification vectorielle, de la même manière que les modules CEn précédemment décrits. Les paramètres de codage délivrés par le module CE0m sont notés QE0m, et représentent un nombre NE0m de bits par fenêtre, qui sont fournis au multiplexeur de sortie 5.

Les nombres de bits NSn, NEn et NE0m sont fournis aux différents modules de quantification vectorielle par une unité 10 d'allocation de bits. Cette unité 10 construit également un en-tête H pour le flux de sortie Φ du codeur. Cet en-tête H décrit la distribution des bits dans le flux binaire. L'unité 10 commande également le multiplexeur 5 pour construire le flux Φ.

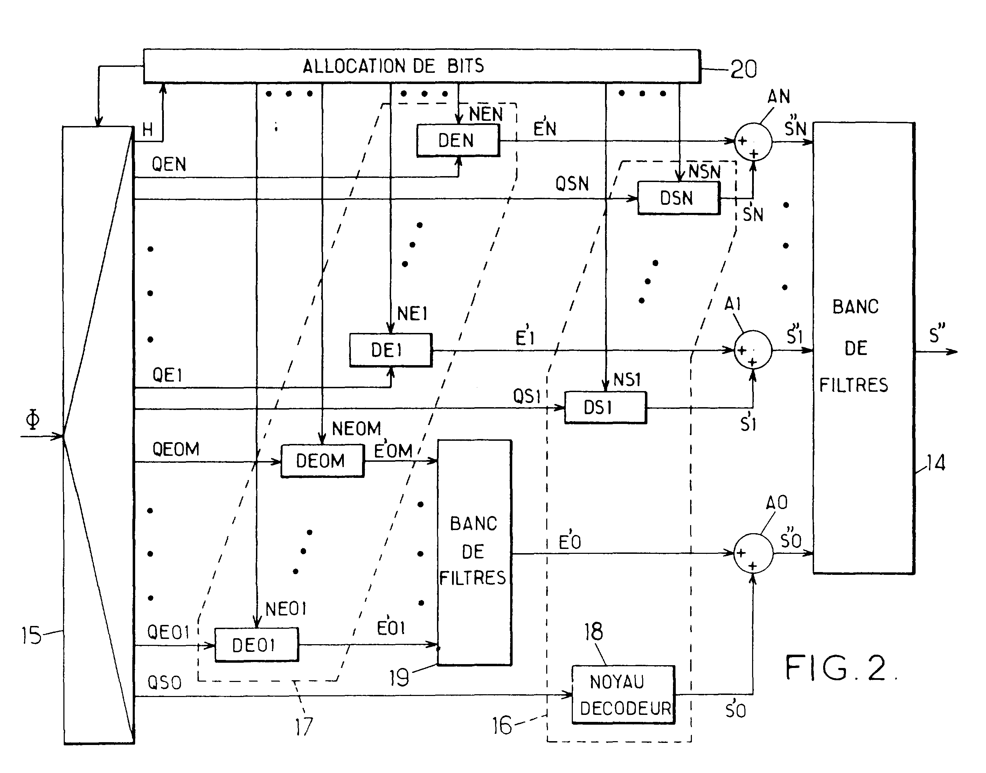

Le décodeur dual représenté sur la figure 2 comporte un démultiplexeur 15 recevant le flux Φ issu du codeur. Le démultiplexeur 15 extrait l'en-tête H et l'adresse à une unité 20 d'allocation de bits. L'unité 20 analyse alors la structure du flux et commande de façon correspondante le démultiplexeur 15 pour qu'il délivre les paramètres pertinents pour les différents modules du décodeur.

Le décodeur comporte un ensemble de modules 17 assurant les opérations inverses des modules de codage du second étage 7 du codeur. L'ensemble 17 comprend ainsi N modules de décodage DE1-DEN qui reconstruisent les estimations E'1-E'N des signaux d'erreur E1-EN, à partir des paramètres de codage QE1-QEN extraits par le démultiplexeur 15. L'ensemble 17 comprend également M modules de décodage DE01-DE0M qui reconstruisent les estimations E'01-E'0M des composantes en sous-bandes E01-E0M du signal d'erreur E0, à partir des paramètres de codage QE01-QE0M extraits par le démultiplexeur 15.

Un banc de filtres de recomposition 19, correspondant au banc de filtres de décomposition 9 du codeur, forme l'estimation E'0 du signal d'erreur E0 à partir des M estimations E'0m de ses composantes en sous-bandes.

Un autre ensemble de modules 16 effectue les opérations de décodage correspondant aux codages effectués dans le premier étage 6 du codeur. Cet ensemble 16 comprend un noyau décodeur 18 qui est un décodeur normalisé associé au noyau codeur 8. Il reconstruit le signal synthétique S'0 du codeur à analyse par synthèse à partir des paramètres de codage QS0 extraits par le démultiplexeur 15. L'ensemble 16 comporte en outre N modules de décodage DS1-DSN qui reconstruisent les estimations S'1-S'N des signaux de bandes élevées S1-SN à partir des paramètres de codage QS1-QSN extraits par le démultiplexeur 15.

N+1 additionneurs A0-AN produisent les N+1 estimations améliorées S"0-S"N des composantes spectrales du signal d'entrée, qui sont soumises à un banc de filtres de recomposition 14. L'additionneur An (0≤n≤N) effectue l'opération S"n = S'n + E'n. Le banc de filtres de recomposition 14 correspond au banc de filtres de décomposition 4 du codeur. Il délivre l'estimation finale S" du signal audio d'origine.

Le codeur décrit ci-dessus utilise un étage 6 de codage principal et un étage 7 d'amélioration par quantification des erreurs. Bien entendu, il serait possible de prévoir d'autres étages d'amélioration, un second étage d'amélioration (c'est-à-dire un troisième étage du codeur) procédant alors à une quantification vectorielle des erreurs résiduelles des différents modules de codage du second étage, et ainsi de suite. De façon correspondante, le décodeur associé comporterait alors d'autres ensembles de modules de décodage du type de l'ensemble 17 représenté sur la figure 2.

Le mode d'allocation des bits entre les différents modules de codage dépend de l'application considérée.

L'allocation des bits peut notamment être fixe. Le Tableau I présente un exemple numérique de répartition du débit binaire du flux de sortie entre les différentes sous-bandes et entre les deux étages du codeur (en excluant le débit relatif au noyau codeur). Dans cet exemple numérique, on a choisi N=4 et un signal de base S0 dans la bande 0-4 kHz, échantillonné à 8 kHz. Le signal d'entrée S a donc une bande passante de 8 kHz. Le noyau codeur 8 est par exemple un codeur G.723 qui traite le signal par trames élémentaires de 30 ms (240 échantillons numériques du signal de base). Les quantifications vectorielles sont opérées sur des fenêtres de 60 échantillons, divisées chacune en quatre segments de 15 échantillons. Les fenêtres sont de 60 ms (deux trames élémentaires du codeur G.723) pour les modules CE01-CE08, et de 30 ms (une trame élémentaire du noyau codeur) pour les modules CS1-CS4 et CE1-CE4.

Pour chaque fenêtre, les nombres de bits par sous-bande sont: NE0m=NSn=NEn=56 pour 1≤m≤8, 1≤n≤4, répartis de la manière suivante
- 6 bits *GG* de quantification scalaire d'un gain moyen sur la fenêtre ;
- 6 bits *GR* de quantification vectorielle de quatre gains résiduels concernant respectivement les quatre segments de la fenêtre ;
- 4×*Q*=40 bits *IF* constituant les indices de quantification des vecteurs de forme d'onde, chaque indice de *Q*=10 bits étant l'adresse, dans le dictionnaire de taille 2^{*Q*}=1024, de la forme d'onde à utiliser pour l'un des segments ; et
- 4 bits σ représentant les signes affectés aux gains globaux (= gain moyen sur la fenêtre + gains résiduels) relatifs aux quatre segments de la fenêtre.

**Tableau I**

| **Sous-bande (kHz)** | **Débit 1**^{**er**} **étage (kbit/s)** | **Débit 2**^{**ème**} **étage (kbit/s)** | **Total par sous-bande (kbit/s)** |
|---|---|---|---|
| **0 - 0,5** | - | 0.9333 | 0.9333 |
| **0,5 - 1** | - | 0.9333 | 0.9333 |
| **1 - 1,5** | - | 0.9333 | 0.9333 |
| **1,5 - 2** | - | 0.9333 | 0.9333 |
| **2 - 2,5** | - | 0.9333 | 0.9333 |
| **2,5 - 3** | - | 0.9333 | 0.9333 |
| **3 - 3,5** | - | 0.9333 | 0.9333 |
| **3,5 - 4** | - | 0.9333 | 0.9333 |
| **4 - 5** | 1.8667 | 1.8667 | 3.7333 |
| **5 - 6** | 1.8667 | 1.8667 | 3.7333 |
| **6 - 7** | 1.8667 | 1.8667 | 3.7333 |
| **7 - 8** | 1.8667 | 1.8667 | 3.7333 |
| **TOTAL** | 7,4667 | 14,9333 | 22,4 |

L'allocation des bits peut également être modifiée en fonction du débit de sortie d du codeur, en ajoutant ou en supprimant des bandes de fréquences élevées et/ou des étages d'amélioration. Ceci permet au codeur de s'adapter au décodeur qui traitera son flux de sortie et à la bande passante du canal de transmission. Ceci est effectué très simplement en annulant certain des nombres de bits NEn, NSn ou NE0m fournis aux modules de codage.

Ainsi, dans l'exemple numérique du Tableau I et avec un noyau codeur de type G.723, le codeur peut avoir une gamme de débit allant de 6,3 kbit/s à 28,7 kbit/s environ selon la qualité et/ou le débit requis. On observe qu'on a une grande flexibilité et une grande finesse dans l'adaptation du débit du codeur.

L'unité d'allocation 10 peut également examiner les énergies respectives des signaux E0m,Sn,CEn fournis aux modules de codage afin de ne pas transmettre de paramètres de codage d'un signal qui serait d'énergie négligeable.

Le codeur peut également s'adapter à différentes largeurs de bande passante et/ou à différentes fréquences d'échantillonnage du signal d'entrée S. Pour cela, on peut ajouter des bandes élevées dans la décomposition initiale en sous-bandes du signal S. Le noyau codeur utilisé peut lui-même être sélectionné parmi plusieurs noyaux codeurs normalisés (G.723, Tetra, MPEG-2 AAC,...) prévus dans le codeur audio, ces différents noyaux codeurs permettant de traiter des signaux de bandes passantes et/ou de fréquences d'échantillonnage différentes.

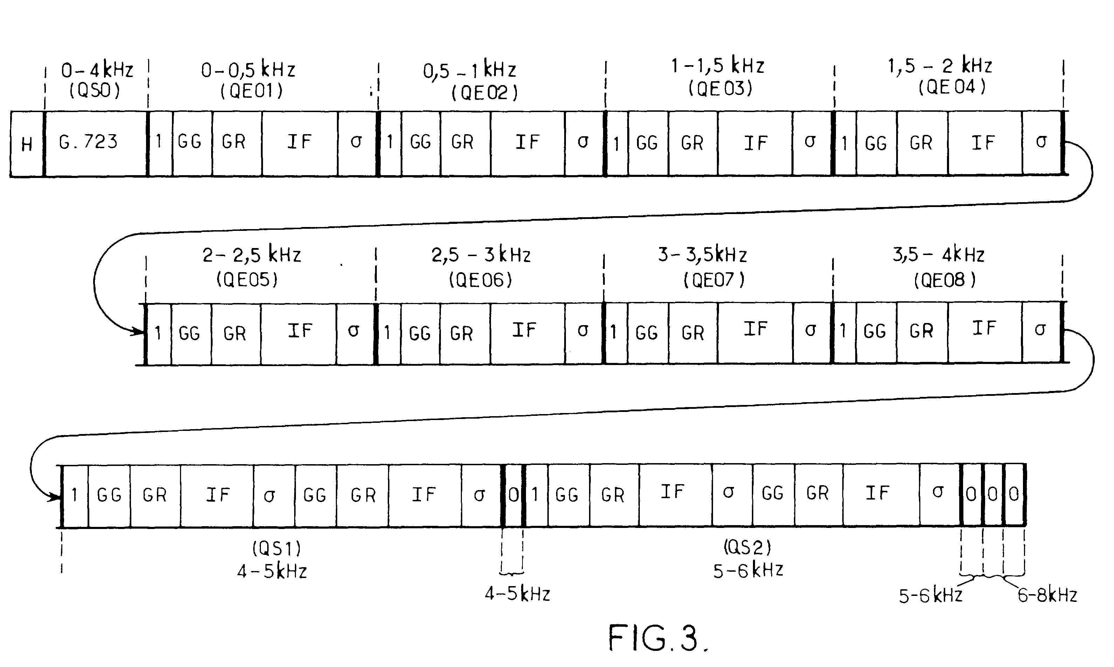

Lorsque l'allocation des bits est variable, il convient d'inclure dans le flux de sortie du codeur des bits d'allocation indiquant les sous-bandes prises en considération. Ces bits d'allocation peuvent être placés dans l'en-tête H du flux. Ils peuvent également être placés avec les bits de quantification correspondants, comme le montre la figure 3.

L'exemple de la figure 3 correspond au cas particulier où l'allocation des bits est telle que les *M*=8 sous-bandes résultant de la décomposition de l'erreur résiduelle E0 du noyau codeur 8, supposé de type G.723 (trames de 30 ms, soit 240 échantillons à 8 kHz), sont prises en considération, de même que les 2 sous-bandes les plus basses parmi les *N*=4 sous-bandes élevées résultant de la décomposition du signal d'entrée *S* (cf. Tableau I).

Le flux représenté sur la figure 3 correspond à une fenêtre temporelle de 60 ms. On suppose que le processus de codage est en deux étages, c'est-à-dire avec un seul étage d'amélioration. L'en-tête H comporte par exemple quatre bits servant à coder le type du noyau codeur employé (G.723 à 6,3 kbit/s, G.723 à 5,3 kbit/s, Tetra, CELP VM à 5,5 kbit/s, etc.), auxquels s'ajoute un bit indiquant la fréquence d'échantillonnage du signal d'entrée (8 kHz ou 16 kHz).

Après l'en-tête H se trouvent les bits représentant les paramètres QS0 fournis par le noyau codeur selon le format normalisé. Dans l'exemple considéré, la fenêtre inclut deux trames G.723, formant la contribution au flux de la bande de base 0-4 kHz pour le premier étage de codage.

Les paramètres G.723 sont suivis par des champs relatifs aux sous-bandes issues de la décomposition du signal d'erreur E0 du noyau codeur, considérées dans l'ordre des fréquences croissantes. Chacun de ces champs se rapporte au second étage du codeur, et commence par le bit d'allocation. Si ce bit d'allocation vaut 1 (pour chacune des huit sous-bandes dans le cas considéré), le flux inclut des paramètres QE0m de codage pour la sous-bande, et les bits représentant ces paramètres *GG, GR, IF* et σ suivent le bit d'allocation, avant de passer à la sous-bande suivante. Si le bit d'allocation vaut 0, la sous-bande concernée n'est pas utilisée, et le bit d'allocation à 0 est directement suivi par le champ relatif à la sous-bande suivante.

Après les champs relatifs aux *M*=8 sous-bandes du signal d'erreur E0, le flux comporte successivement les champs contenant les informations relatives aux *N*=4 bandes élevées de la décomposition du signal d'entrée, considérées dans l'ordre des fréquences croissantes (ces champs sont absents si l'en-tête H indique que la fréquence d'échantillonnage est de 8 kHz seulement). Chacun de ces champs se rapporte au premier étage et éventuellement au second étage du codeur, et commence par un bit d'allocation. Si ce bit d'allocation vaut 0 (pour les deux dernières bandes élevées dans le cas considéré), la bande concernée n'est pas utilisée, et le bit d'allocation à 0 est directement suivi par le champ relatif à la bande suivante (il n'est pas nécessaire de prévoir un bit d'allocation supplémentaire pour le second étage). Si le bit d'allocation vaut 1 (pour les deux premières bandes élevées dans le cas considéré), le flux inclut deux jeux de paramètres QSn de codage du premier étage pour la bande en question, et les bits représentant ces paramètres *GG, GR, IF* et a suivent le bit d'allocation (il y a deux jeux de NS1=NS2=56 bits parce que les fenêtres de quantification de 60 échantillons sont de 30 ms seulement pour les bandes élevées) ; le flux comporte ensuite le bit d'allocation supplémentaire pour le second étage qui est à son tour suivi, le cas échéant, par les bits représentant les paramètres de codage QEn relatifs au second étage.

On notera que le format illustré par la figure 3 est adapté à des contenus très variés du flux. Il permet la prise en compte de divers noyaux codeurs, et de très nombreuses possibilités dans l'allocation des bits par sous-bandes, desquelles résultent de nombreuses valeurs possibles du débit. Ce flux est dit « éditable » dans la mesure où il permet de récupérer l'information codée morceau par morceau (ici bande par bande). Si par exemple un décodeur limité à la fréquence d'échantillonnage de 8 kHz reçoit le flux représenté sur la figure 3, lequel est destiné a priori à un décodeur fonctionnant à 16 kHz, il pourra néanmoins restituer une version du signal audio codé, simplement en ne tenant pas compte de l'information concernant les bandes élevées.

Avec les valeurs du Tableau I et un noyau codeur G.723 à 6,3 kbit/s, le flux représenté sur la figure 3 code la fenêtre de signal de 60 ms en *A*=1069 bits ordonnés, correspondant à un débit de 17,8 kbit/s. Si le signal d'entrée est échantillonné à 8 kHz seulement, le bit correspondant de l'en-tête est modifié, et l'information concernant les bandes élevées est supprimée (dernière ligne de la figure 3) : la fenêtre est alors de *A*=839 bits ordonnés, correspondant à un débit de 14 kbit/s. Si une réduction supplémentaire du débit est nécessaire, la solution la plus simple est de supprimer la ou les sous-bandes les plus élevées dans la décomposition du signal d'erreur, ce qui entraîne une certaine dégradation de la qualité. Si par exemple le débit doit être ramené à 12,9 kbit/s, on supprime les deux sous-bandes les plus élevées.

Dans un mode de réalisation de l'invention, une réduction du débit résulte d'une suppression portant sur certains bits seulement d'un ou plusieurs indices de quantification vectorielle.

A titre d'exemple, on considère ci-après les indices *IF* de quantification des formes d'onde. On notera toutefois qu'un procédé analogue pourrait être appliqué à tout vecteur de paramètres que le décodeur peut récupérer à partir d'indices de quantification vectorielle pointant dans des dictionnaires prédéterminés. En particulier, on pourrait l'appliquer au vecteur d'excitation stochastique utilisé dans les codeurs de type CELP ou analogue.

Pour chaque segment d'un signal E0m, Sn ou En soumis à la quantification vectorielle, le codeur est capable de produire l'adresse, représentée par un indice *IF* de *Q*=10 bits (exemple du Tableau I), qui désigne dans le dictionnaire de référence de 2^{*Q*} vecteurs la forme d'onde de 60 échantillons considérée comme optimale au sens de la minimisation de l'erreur de quantification sur un corpus d'apprentissage.

Si seulement *Q-p* bits de cet indice *IF* (*1≤p≤Q*) sont transmis au décodeur, celui-ci saura que l'adresse du vecteur sélectionné par le codeur fait partie d'un groupe de 2^{*Q-p*} adresses représentées par les différents indices de *Q* bits qui partagent les *Q-p* bits reçus. Le décodeur pourra alors soit choisir l'un des vecteurs pointés par les 2^{*Q-p*} adresses du groupe, soit en calculer une moyenne pour obtenir la forme d'onde utilisée pour reconstruire le signal.

Plus généralement, les indices transmis de *Q-p* bits sont obtenus par troncature de *p* bits de positions déterminées dans des indices de *Q* bits qui correspondent aux adresses du dictionnaire de référence par une permutation arbitraire (connue de l'émetteur et du récepteur) dans l'intervalle [0, 2^{*Q*}[. Sans restreindre la généralité, on peut étudier le cas où les bits tronqués sont les *p* derniers bits (poids faibles) des indices.

Cette troncature peut être effectuée soit par le codeur à l'origine du flux binaire Φ (il suffit alors que l'unité d'allocation 10 fournisse les nombres de bits pertinents aux modules de codage CSn, CEn ou CE0m), soit par un transcodeur intermédiaire recevant le flux d'origine Φ (ou un flux déjà transcodé) et le transformant en un flux de moindre débit Φ'. La troncature est effectuée pour un ou plusieurs des vecteurs de quantification, voire pour tous. Le codeur ou transcodeur qui l'effectue peut inclure dans le flux binaire, par exemple dans les en-têtes H, des informations décrivant la structure modifiée du flux en termes de nombres de bits des différents indices, à moins que ces informations soit déjà connues du décodeur.

Cette façon de procéder procure une granularité de débit beaucoup plus fine que lorsqu'on joue simplement sur le nombre de sous-bandes prises en considération.

On considère d'abord le cas où ladite permutation dans l'intervalle [0, 2^{*Q*}[ est l'identité, l'indice non tronqué étant égal à l'adresse du vecteur sélectionné par le codeur. Le cas contraire, où une table ou relation de transcodage est utilisée pour rendre compte de la permutation, sera considéré plus loin.

Il est possible d'adopter un ordonnancement adéquat du dictionnaire de référence, pour faire en sorte que, pour une ou plusieurs valeurs de l'entier *p*, les 2^{*p*} vecteurs désignés par les adresses du groupe soient proches les uns des autres au sens d'un critère de distance, de façon à minimiser l'altération du signal décodé que peut causer la réduction du nombre de bits de l'indice transmis.

Il existe diverses méthodes classiques de construction de dictionnaires de référence pour des processus de quantification vectorielle, déterminés pour modéliser de façon optimale la forme du signal à quantifier. Par exemple, la méthode LBG permet d'obtenir, pour différentes valeurs de l'entier *Q*, des dictionnaires de taille 2^{*Q*} qui minimisent l'erreur quadratique moyenne lors de la quantification d'un corpus de signaux représentatifs.

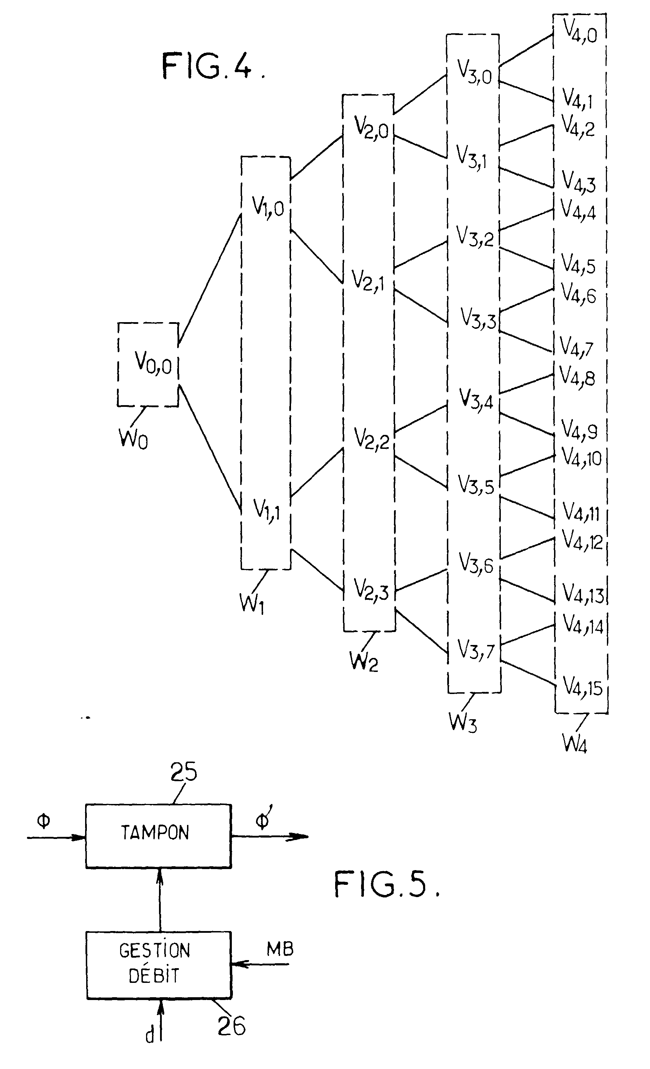

De tels dictionnaires peuvent être générés par une procédure arborescente illustrée par la figure 4. Cette figure montre des dictionnaires *W*_{*i*} composés chacun de 2^{*i*} vecteurs *V*_{*ij*} (0≤*j*≤2^{*i*}) générés itérativement à partir de *i*=0 de façon que leurs combinaisons linéaires recouvrent au mieux l'espace des signaux à quantifier. Pour chaque valeur de *i,* les vecteurs *V*_{*i*}_{+1,2}_{*j*} et *V*_{*i*}_{+1,2}_{*j+1*} sont dérivés du vecteur-père *V*_{*ij*} dont ils sont les plus proches. Une fois que *Q* itérations ont été effectuées, on adopte le dictionnaire *W*_{*Q*} comme dictionnaire de référence et les index *j* des vecteurs *V*_{*Qj*} comme adresses. Cette construction connue de dictionnaires est généralement utilisée dans le but d'accélérer la recherche du vecteur optimal, en procédant à la recherche de la racine vers les ramifications de l'arbre, ce qui nécessite que le codeur mémorise une partie au moins des dictionnaires intermédiaires *W*_{*i*} (*i<Q*) en plus du dictionnaire *W*_{*Q*}. Dans la présente application, on utilise cette construction afin de s'assurer que, pour toute valeur de *p*, les 2^{*p*} vecteurs désignés par les adresses d'un groupe de 2^{*p*} adresses partageant leurs *Q-p* bits de poids les plus forts soient relativement proches les uns des autres, ce qui minimise les distorsions provoquées par la transmission d'un nombre restreint de bits de l'indice.

Le module de décodage DSn, DEn ou DE0m recevant les *Q-p* bits de l'indice tronqué peut les compléter par *p* bits de valeurs arbitraires à la place des *p* bits manquants pour former l'adresse d'accès dans le dictionnaire de référence.

Si le spectre du signal quantifié est blanc, ce qui est le cas en bonne approximation pour les signaux d'erreur résiduelle E0m et En, il a alors une chance sur 2^{*p*} d'utiliser le vecteur optimal. Pour limiter les biais, il est préférable de tirer au hasard les *p* bits ajoutés à l'indice reçu.

Dans certains cas, les *p* bits ajoutés à l'indice reçu par le décodeur peuvent être de valeurs prédéterminées, par exemple 00... 0. Cela peut être le cas si le module de quantification vectorielle CSn, CEn ou CE0m du codeur sélectionne le vecteur de paramètres de codage dans un sous-dictionnaire de 2^{*Q-p*} vecteurs inclus dans le dictionnaire de référence, contenant seulement les vecteurs dont l'adresse se termine par *p* bits à zéro. Les *Q-p* bits de l'indice transmis, complétés par *p* bits de poids faibles à zéro représentent alors l'adresse du vecteur sélectionné dans le dictionnaire de référence.

Une autre possibilité pour le module de décodage DSn, DEn ou DE0m du décodeur, recevant un indice de *Q-p* bits seulement, est de calculer pour former son signal de sortie une moyenne des 2^{*p*} vecteurs dont les adresses commencent par ces *Q-p* bits.

Si la statistique du signal quantifié est uniforme, il y a intérêt à ce que cette moyenne soit uniforme, c'est-à-dire non pondérée.

Si la statistique du signal quantifié n'est pas uniforme, ce qui peut être le cas par exemple pour les signaux S1-SN dans le codeur de la figure 1, une pondération sera de préférence utilisée dans le calcul de moyenne par le décodeur. Dans ce cas, on utilise préalablement une base de données représentative de la statistique des signaux traités pour associer à chaque vecteur du dictionnaire un coefficient représentant sa probabilité d'occurrence a priori. Ces coefficients étant fixés, on peut ensuite s'en servir pour pondérer les moyennes de façon à limiter les distorsions dues à la suppression de certains bits du flux.

Il est également possible que le décodeur adopte, pour obtenir la forme d'onde, une méthode qui tienne compte d'une information sur le signal codé.

Cette information peut notamment se rapporter au caractère stationnaire ou non stationnaire du signal. Elle peut soit être transmise par le codeur dans le flux binaire, par exemple dans l'en-tête H, soit être obtenue par le décodeur par une analyse a posteriori du signal décodé. Des méthodes d'analyse du caractère stationnaire du signal, par exemple de détection voisé/non voisé, sont bien connues dans le domaine du codage de parole.

On peut établir a priori plusieurs tables de coefficients pondérateurs associés aux vecteurs du dictionnaire de référence, par exemple une table représentative de la statistique des signaux de type stationnaire, et une autre table représentative de la statistique des signaux de type non stationnaire, et choisir dynamiquement la table employée pour récupérer les coefficients pondérateurs de la moyenne sur la base de l'information sur le caractère stationnaire du signal.

Dans le cas où un vecteur est simplement sélectionné dans le groupe de 2^{*p*} vecteurs, la sélection peut également être différente selon une information sur le signal telle qu'un degré de stationnarité.

Une autre analyse que peut effectuer le module de décodage dans le cadre de la récupération du vecteur de paramètres de codage repose sur une prédiction de ce vecteur. On peut ainsi soumettre la séquence des vecteurs, récupérés par le module de décodage concerné pour les fenêtres temporelles successives, à une prédiction linéaire afin d'obtenir un vecteur prédit pour la fenêtre courante. Deux possibilités sont alors offertes : retenir finalement celui des 2^{*p*} vecteurs du groupe dont les adresses commencent par les *Q-p* bits de l'indice reçu qui présente une similitude maximale, ou une distance minimale, avec le vecteur prédit ; ou tenir compte de ce vecteur prédit dans l'affectation des coefficients pondérateurs si un calcul de moyenne pondéré est effectué, un poids maximal étant alors affecté à celui des 2^{*p*} vecteurs qui présente une similitude maximale avec le vecteur prédit.

Les différentes méthodes qui ont été décrites ci-dessus pour l'obtention du vecteur à partir de l'indice incomplet peuvent coexister dans le même décodeur, et être sélectionnées sur la base d'informations contenues dans le flux ou transmises dans une signalisation préalable à la communication. D'autre part, chaque vecteur étant formé par un module de décodage respectif DSn, DEn ou DE0m, on pourra prévoir que des méthodes différentes soient appliquées par ces modules pour l'obtention du vecteur à partir de l'indice incomplet. D'ailleurs, les différents modules de codage et de décodage associés pourraient utiliser des dictionnaires de référence différents.

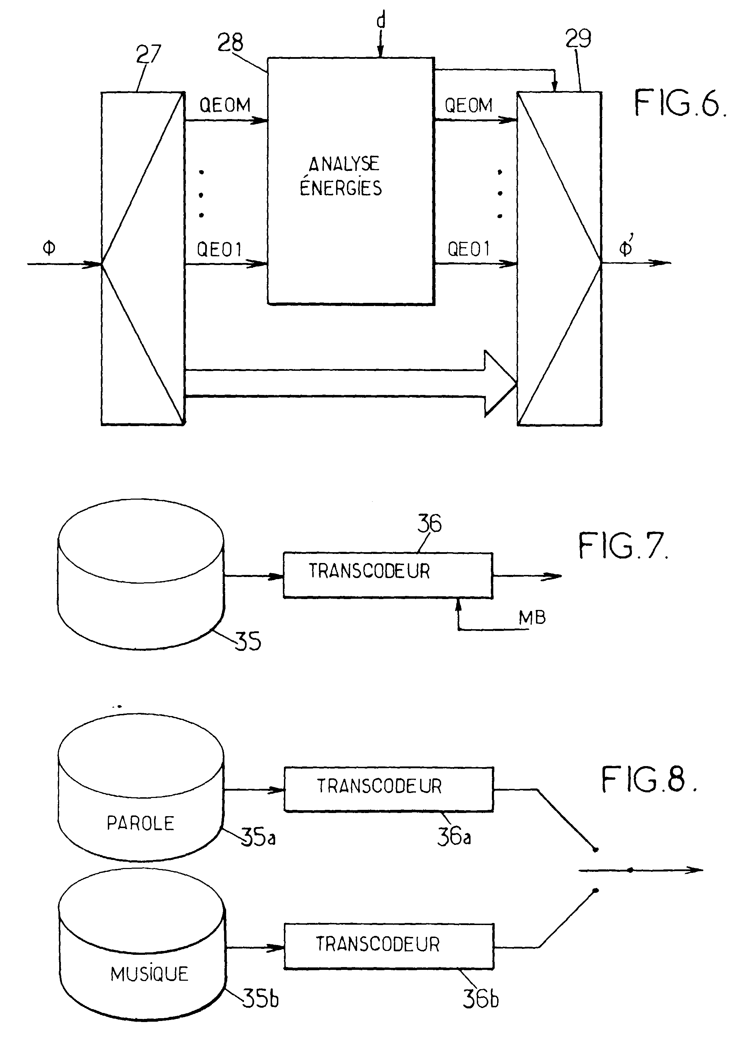

Les figures 5 et 6 sont des schémas synoptiques de transcodeurs pouvant effectuer la suppression de certains bits d'un ou plusieurs indices.

Il est à noter que le flux d'entrée Φ du transcodeur peut avoir déjà fait l'objet d'une suppression de bits de poids les plus faibles de certains des indices de quantification vectorielle, soit par le codeur à l'origine du flux, soit par un autre transcodeur intermédiaire. Un indice de *Q-q* bits du flux d'entrée Φ (avec *q*≥0 dans le cas général) est ainsi réduit à un indice de *Q-p* bits, avec *p>q,* dans le flux de sortie Φ' du transcodeur.

Dans l'architecture de la figure 5, le flux binaire d'entrée Φ est écrit dans une mémoire tampon 25. Des parties en sont ensuite lues dans la mémoire 25 pour former le flux de sortie Φ'. Le contrôle des bits lus et supprimés est effectué par une unité de gestion de débit 26 recevant une valeur de débit de sortie *d* à respecter. En fonction du débit *d,* l'unité 26 détermine quels bits doivent être supprimés. A titre d'exemple, pour des valeurs de *d* décroissantes, elle peut commencer par supprimer un bit par module de codage, en commençant, selon la composition du flux d'entrée Φ, par les derniers étages du codeur et par les sous-bandes les plus élevées. Bien entendu d'autres stratégies de choix des bits supprimés seraient applicables. Comme le montre la figure 5, le transcodeur pourrait aussi recevoir des messages MB de la part du récepteur afin d'en tenir compte dans la construction du flux de sortie Φ'.

Dans l'architecture de la figure 6, le transcodeur comporte un démultiplexeur d'entrée 27 qui reçoit le flux d'entrée Φ et sépare certains indices de quantification (les indices QE0m seulement dans l'exemple dessiné) du reste du flux. Une unité d'analyse énergétique 28 examine les indices QE0m et en supprime certains bits avant de fournir les indices tronqués à un multiplexeur de sortie 29 qui, avec les autres éléments du flux d'entrée Φ, forme le flux de sortie Φ'.

Pour chaque jeu d'indices QE0m={*GG, GR*, *IF, σ},* l'unité 28 estime l'énergie du signal quantifié, mesurée par les indices de gains lorsque les formes d'onde sont normalisées. En fonction du débit de sortie *d* requis, elle supprime des bits des indices de quantification *IF* des formes d'onde, en commençant par ceux appartenant aux jeux d'indices pour lesquels les énergies estimées sont les plus faibles. On sélectionne ainsi, dans l'ensemble de composantes spectrales, une ou plusieurs composantes dont les énergies sont minimales, afin de remplacer l'indice *IF* du jeu d'indices de quantification associé à chaque composante sélectionnée par un indice tronqué.

On note que le codeur pourrait dès l'origine adopter une stratégie semblable.

Un décodeur recevant le flux de sortie Φ' ainsi construit estime de la même façon les énergies sur la base des indices de gain (qui ne sont pas modifiés), ce qui lui permet d'identifier les sous-bandes pour lesquelles des bits des indices *IF* ont été supprimés. Le démultiplexeur d'entrée 15 de ce décodeur est associé à une unité d'analyse énergétique du même genre que l'unité 28 de la figure 6. L'unité d'analyse énergétique du décodeur, qui peut faire partie de l'unité d'allocation de bits dans le schéma de la figure 2, reçoit les indices de gains *GG, GR,* σ pour les différentes composantes quantifiées afin d'identifier les composantes les moins énergétiques et d'affecter un nombre réduit de bits à leurs indices de quantification de forme *IF.* Elle commande le démultiplexeur d'entrée 15 et les modules de décodage DSn, DEn, DE0m pour que les bits des indices soient convenablement distribués. Pour que le décodeur puisse correctement identifier les indices reçus, il convient de modifier l'ordonnancement des bits dans le flux par rapport à la structure représentée sur la figure 3, par exemple de façon à placer les indices de gain *GG, GR,* σ avant les indices de forme *IF.*

Cette façon d'opérer le codage/transcodage et le décodage oriente les erreurs vers les portions les moins énergétiques du signal, ce qui limite la perception des distorsions.

Le transcodeur de la figure 5 ou 6 peut notamment être placé à un noeud d'un réseau de télécommunications utilisé pour transmettre le flux binaire. Le flux binaire d'entrée Φ est alors reçu sur une liaison du réseau, et le flux binaire de sortie Φ' est réémis sur une autre liaison du même réseau, ou sur une liaison d'un réseau différent dans le cas d'une passerelle. Le réseau en question peut notamment être un réseau à commutation de paquets, tel qu'un réseau Internet ou ATM. Dans un tel réseau, il est souhaitable de pouvoir adapter dynamiquement, et de préférence finement, le débit de transmission pour éviter des retards de transmission dus à un trafic encombré, retards qui ne sont généralement pas admissibles pour des signaux audio.

Dans certaines applications, le transcodeur peut encore être situé à l'endroit d'où provient le signal codé. Il peut notamment être associé à un serveur audio, comme schématisé sur la figure 7 ou 8.

Dans l'exemple de la figure 7, une mémoire 35 du serveur audio contient un certain nombre de séquences de signal préalablement codées au débit maximal du processus de codage (dans l'exemple considéré plus haut : NE01=...=NE0M=NS1=...=NSN=NE1=... ...=NEN=56).

Lorsque le serveur doit produire une séquence donnée à destination d'un décodeur, ayant par exemple fait connaître dans un message MB ses caractéristiques pertinentes (et/ou une indication des sous-bandes pour lesquelles des bits peuvent être supprimés), le transcodeur 36 obtient le flux à plein débit lu dans la mémoire 35 et supprime, pour effectuer la transmission selon un débit plus faible, des bits de quantification déterminés comme décrit précédemment.

Les bits supprimés peuvent également être choisis en fonction de l'origine du signal codé. La figure 8 montre ainsi un autre serveur audio dans lequel des transcodeurs mettent en oeuvre l'invention sans nécessairement analyser les flux transmis ou recevoir de messages MB issus d'un décodeur. Dans l'exemple de la figure 8, la mémoire du serveur est divisée en deux zones, l'une 35a dans laquelle on a enregistré les séquences codées à plein débit correspondant à des signaux de parole, et l'autre 35b dans laquelle on a enregistré les séquences codées à plein débit correspondant à des signaux de musique. Chaque séquence lue dans la zone 35a est soumise à un transcodeur 36a qui réduit son débit lorsque c'est nécessaire, en privilégiant la suppression de bits relatifs aux sous-bandes de décomposition du signal d'erreur E0. A l'inverse, les séquences lues dans la zone 35b sont soumises à un transcodeur 36b qui, lorsque c'est nécessaire, supprime des bits de quantification préférentiellement dans les bandes élevées afin de privilégier la correction des distorsions que le noyau codeur a pu introduire dans la bande de base.

Le procédé de codage ou de transcodage, selon lequel on transmet un nombre de bits *Q-p* plus faible que le nombre de bits *Q* des adresses des vecteurs dans le dictionnaire de référence, peut également être appliqué au noyau codeur, ou plus généralement à tout codeur de forme d'onde faisant appel à un dictionnaire par exemple CELP ou autre. Ces codeurs sont développés dans le cadre d'applications dans lesquelles la présente invention n'est normalement pas prise en compte. Cela conduit à des dictionnaires de référence dont l'ordonnancement ne remplit pas a priori la condition de distances réduites entre vecteurs dont les adresses partagent leurs bits de poids les plus forts.

Partant d'un tel dictionnaire de référence de taille 2^{*Q*}, on peut ordonner les vecteurs qui le composent de façon à leur associer respectivement des indices de *Q* bits en plus de leurs adresses dans le dictionnaire, conduisant à vérifier un critère de distances minimales entre les vecteurs appartenant à chaque groupe de 2^{*p*} vecteurs du dictionnaire dont les indices de *Q* bits respectifs ne diffèrent que par les *p* bits de poids les plus faibles. Cet ordonnancement peut être réalisé pour une seule ou pour plusieurs valeurs de l'entier *p*. Il conduit à la définition d'une ou plusieurs relations ou tables de transcodage déterminant un indice de *Q* bits pour représenter l'adresse sur *Q* bits de chaque vecteur du dictionnaire. Cette table est telle que les vecteurs de chaque groupe de 2^{*p*} vecteurs, dont les adresses sont représentées par 2^{*p*} indices de *Q* bits ne différant les uns des autres que par leurs *p* bits de poids les plus faibles, soient relativement proches les uns des autres.

Trouver la permutation qui minimise rigoureusement les distances au sein de l'ensemble des groupes possibles de 2^{*p*} vecteurs est un problème d'optimisation ardu qui requiert une quantité énorme de calculs. On peut toutefois identifier des solutions sous-optimales utilisables pratiquement. A titre d'exemple, on peut procéder comme suit :
/a/ prendre la liste des adresses de *Q* bits dans le dictionnaire initial à réordonner comme ensemble A = {0, 1, ..., 2^{*Q*}-1} ;
/b/ pour *k* allant de 0 à 2^{*Q-p*}-1, faire :
   /b1/ tirer au hasard dans l'ensemble A une adresse b(*k*.2^{*p*}) ;
   /b2/ enlever b(*k*.2^{*p*}) de l'ensemble A ;
   /b3/ pour *h* allant de 1 à 2^{*p*}-1, faire :
      /b3.1/ choisir dans l'ensemble A l'adresse b(*k.2*^{*p*}*+h*) qui désigne le vecteur dont la distance au vecteur désigné par l'adresse b(*k.2*^{*p*}) est minimale ;
      /b3.2/ enlever b(*k.2*^{*p*}*+h*) de l'ensemble A ;
/c/ mémoriser la liste d'indices traduits B = {b(0), b(1), ..., b(2^{*Q*}-1)}.

On peut exécuter l'algorithme ci-dessus un grand nombre de fois, et retenir finalement celle des listes B pour laquelle la distorsion calculée, sur un corpus de signaux représentatifs, en appliquant le procédé ci-dessus de réduction de débit, est minimale.

La table de transcodage utilisée par le décodeur associe l'adresse b(*j*') à chaque entier *j*' compris entre 0 et 2^{*Q*}-1 formant un indice de *Q* bits. Le codeur ou le transcodeur utilise la table inverse, qui associe à chaque adresse *j* de *Q* bits, initialement fournie par le processus normal de codage, l'indice b⁻¹(*j*) tel que b[b⁻¹(*j*)]=*j*. Un troncature de *p* bits de poids faible de l'indice b⁻¹(*j*) ne conduit alors qu'à des erreurs limitées dans l'obtention du vecteur de codage par le décodeur.

On notera que de nombreuses variantes peuvent être apportées à l'algorithme de réordonnancement de dictionnaire exposé ci-dessus. Par exemple, si *p*≥2, on pourrait choisir l'adresse b(*k.2*^{*p*}*+h*) à l'étape /b3.1/ comme désignant le vecteur dont la somme des distances aux vecteurs respectivement désignés par les adresses *b*(*k.2*^{*p*}) à *b*(*k.2*^{*P*}*+h*-1) est minimale.

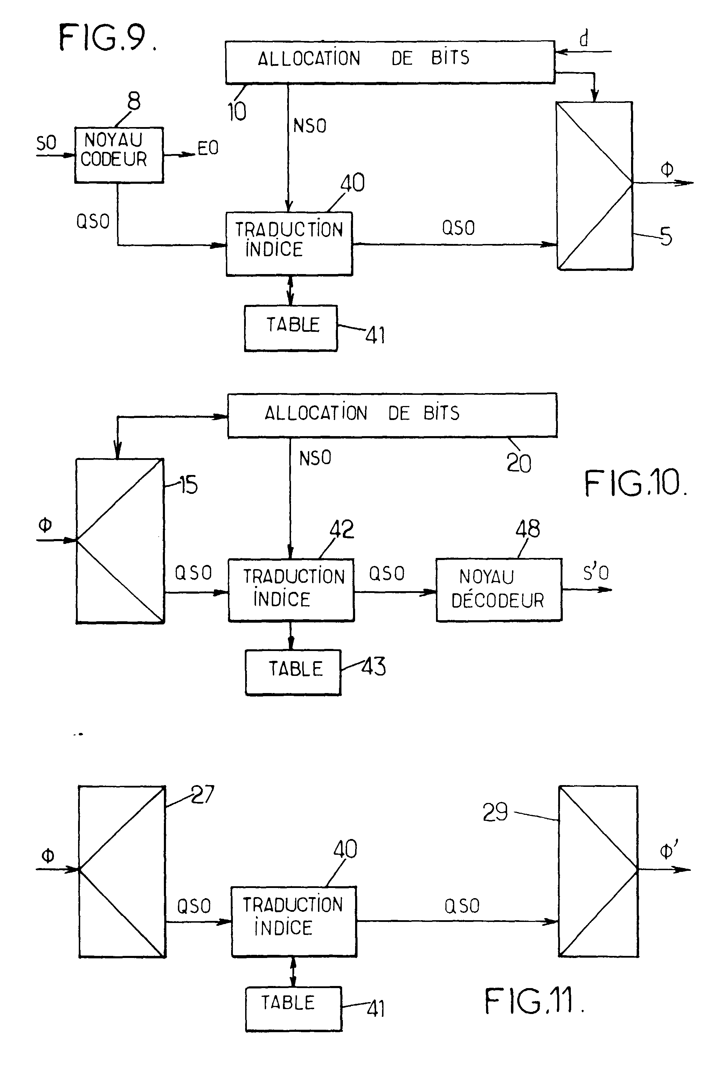

Les figures 9, 10 et 11 montrent schématiquement des variantes du codeur, du décodeur et du transcodeur des figures 1, 2 et 5, utilisant des tables de transcodage telles que décrites ci-dessus. Les éléments non concernés directement par ces tables n'ont pas été redessinés.

Dans le codeur de la figure 9, les indices de quantification délivrés de façon normale par le noyau codeur 8 sont fournis à un module 40 de traduction de l'indice de l'excitation stochastique CELP. Ce module 40 reçoit du module d'allocation 10 un nombre de bits NS0 qui tient compte, en ce qui concerne le vecteur d'excitation sélectionné dans le dictionnaire CELP, d'un nombre de bits *Q-p* plus petit que le nombre de bits *Q* des adresses servant dans ce dictionnaire (*p*≥1). Le module 40 consulte la table de transcodage 41 pour récupérer l'indice de *Q* bits b⁻¹(*j*) représentant l'adresse *j* reçue du noyau codeur 8 parmi les paramètres QS0. Il enlève les p bits de poids les plus faibles de cet indice b⁻¹(*j*) pour former l'indice inclus dans le flux binaire de sortie Φ formé par le multiplexeur 5.

Avant de parvenir au décodeur, ce flux binaire Φ peut éventuellement faire l'objet d'un transcodage intermédiaire comportant la suppression d'un ou plusieurs autres bits de poids faible de l'indice relatif au vecteur d'excitation CELP, par un transcodeur du type précédemment décrit.

Dans le décodeur représenté sur la figure 10, les indices QS0 concernant le noyau décodeur, dont l'indice tronqué par le module 40 du codeur, sont fournis à un autre module de traduction 42. Celui-ci consulte la table de transcodage 43 afin de récupérer une ou plusieurs adresses de *Q* bits b(*j*') représentées par des indices *j*' formés par les *Q-p* bits de l'indice tronqué complétés par *p* bits de poids faible. Ces adresses b(*j*') désignent des vecteurs du dictionnaire CELP que le noyau décodeur 18 utilise pour reconstituer le signal de base S'0.

Le module 42 du décodeur peut fonctionner par sélection d'un vecteur parmi le groupe de 2^{*p*} vecteurs CELP dont les adresses sont représentées par les 2^{*p*} valeurs possibles de l'indice *j*', selon les mêmes méthodes de sélection que précédemment. L'adresse de ce vecteur est alors fournie au noyau décodeur 18 qui fonctionne de façon classique.

Le module 42 peut aussi coopérer avec le noyau décodeur 18 pour fonctionner par moyennage, uniforme ou pondéré des 2^{*p*} vecteurs de ce groupe, selon les mêmes méthodes de pondération que précédemment.

La méthode de sélection ou de moyennage employée peut également être choisie dynamiquement.

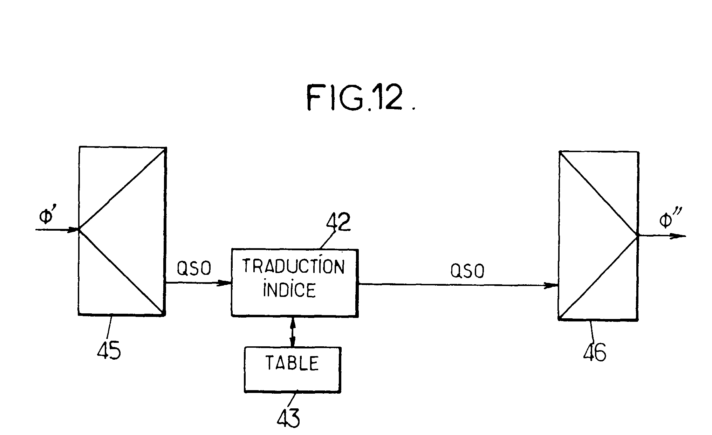

Dans le transcodeur de la figure 11, un module de traduction 40 identique à celui du codeur de la figure 9 reçoit les indices QS0, fournis par le démultiplexeur d'entrée 27, qui ont été obtenus sans transcodage par le noyau codeur 8. Ces indices comprennent un indice de *Q* bits égal à l'adresse du vecteur sélectionné dans le dictionnaire CELP. Le module 40 consulte la table de transcodage 41 sur la base de cette adresse pour récupérer l'indice de *Q* bits correspondant, et en enlève les *p* bits de poids les plus faibles avant de le retransmettre au multiplexeur 29 qui forme le flux de sortie Φ'. Ce flux Φ' pourra être traité par le décodeur de la figure 10.

La figure 12 montre un autre transcodeur opérant le transcodage inverse de celui de la figure 11. Il reçoit un flux d'entrée Φ' de débit réduit, notamment en ce que l'indice relatif au vecteur d'excitation CELP fait *Q-p* bits au lieu de *Q*, et il délivre un flux Φ" de débit plus élevé dans lequel cet indice a été ramené à *Q* bits. Le flux d'entrée Φ' peut avoir été produit par un codeur selon la figure 9 ou par un transcodeur selon la figure 11. Le démultiplexeur d'entrée 45 extrait l'indice de *Q-p* bits faisant partie des paramètres QS0, et le fournit à un module de traduction 42 identique à celui du décodeur de la figure 10, qui consulte une table de transcodage 43. Le module 42 du transcodeur ne coopère pas avec un noyau décodeur, de sorte qu'il est agencé pour mettre en oeuvre une ou plusieurs des méthodes de sélection de vecteur décrites précédemment (et non une méthode de moyennage), afin que le vecteur sélectionné selon l'une ou l'autre méthode puisse être désigné par son adresse dans le flux de sortie Φ" délivré par le multiplexeur 46.

Un avantage important des codeur, décodeur et transcodeurs décrits en référence aux figures 9 à 12 est qu'ils permettent de réaliser l'échelonnabilité souhaitée y compris pour des codeurs ou décodeurs qui n'auraient pas été conçus à cet effet.

Par exemple, un codeur préexistant à débit de sortie fixe pourra émettre vers un canal de transmission dont des portions n'autorisent, de façon permanente ou temporaire, que des débits plus faibles. Il suffit pour cela qu'un transcodeur du type représenté sur la figure 11 soit situé en sortie de ce codeur ou en un noeud du réseau situé en amont des portions à débit plus faible.

De même, un décodeur préexistant à débit d'entrée fixe pourra recevoir par l'intermédiaire d'un tel canal de transmission. Il suffit pour cela qu'un transcodeur du type représenté sur la figure 12 soit situé en entrée de ce décodeur ou en un noeud du réseau situé en aval des portions à débit plus faible.

On peut en outre prévoir deux modes de fonctionnement pour de tels codeurs et décodeurs. Dans le premier mode, le codeur tronque à *Q-p* bits l'indice du vecteur d'excitation CELP comme expliqué ci-dessus, et le décodeur reconstitue une excitation à partir de l'indice tronqué. Dans le second mode, le codeur et le décodeur fonctionnent comme un codeur et un décodeur CELP ordinaire, avec transmission directe des adresses sur *Q* bits au lieu des indices tronqués. Le codec peut alors adopter l'un ou l'autre des deux modes de fonctionnement selon les capacités de l'autre codec avec lequel il communique et/ou selon les caractéristiques des canaux de transmission empruntés.

Dans le premier mode de fonctionnement, les *p* bits récupérés sur le débit du flux binaire peuvent servir à une réduction effective du débit de la communication. On peut également envisager de se servir de cette capacité pour transmettre d'autres informations au décodeur. Dans ce cas, pour fenêtre temporelle dans laquelle la troncature est appliquée, le codeur insère dans le flux binaire de sortie *p*' bits d'information supplémentaire (0<*p*'≤*p*), que le décodeur reçoit et exploite de façon appropriée.

Les considérations ci-dessus, relatives à la réduction du nombre de bits d'un ou plusieurs indices de quantification, s'appliquent à une structure de codec dont le principe est illustré par les figures 1 et 2, et de façon semblable à toute structure de codec générant un ou plusieurs paramètres quantifiés vectoriellement. Si on considère les seuls codeurs audio, on peut citer les systèmes dans lesquels des gains, des formes d'onde et/ou des composantes fréquentielles du signal sont quantifiés vectoriellement. Le processus est donc applicable aux codecs CELP et dérivés, MP-LPC (« Multi Pulse - Linear Prediction Coding »), en sous-bandes, MBE (« Multi Band Excited »), etc. Il l'est également pour le codage d'autres signaux, notamment vidéo.

## Revendications

1. Procédé de codage d'un signal, dans lequel on sélectionne, sur la base d'une portion du signal (S), au moins un vecteur de paramètres de codage appartenant à un dictionnaire de référence contenant 2^{*Q*} vecteurs désignés chacun par une adresse de *Q* bits, et on forme un flux binaire de sortie (Φ) contenant un indice déduit de l'adresse du vecteur sélectionné dans le dictionnaire de référence, caractérisé en ce que le flux binaire de sortie a un débit réglable en jouant sur le nombre *Q-p* de bits formant ledit indice contenu dans le flux binaire, et en ce que, pour chaque valeur de débit correspondant à une valeur de l'entier *p*≥0, l'indice contenu dans le flux binaire est formé de *Q-p* bits qui, complétés par *p* bits arbitraires de positions prédéterminées, définissent des indices de *Q* bits représentant un groupe de 2^{*p*} adresses incluant l'adresse du vecteur sélectionné dans le dictionnaire de référence.

2. Procédé de codage selon la revendication 1, dans lequel on inclut dans le flux binaire de sortie (Φ) une information représentative du nombre *Q-p* de bits formant ledit indice.

3. Procédé de codage selon la revendication 1 ou 2, dans lequel le signal codé est un signal audio codé en sous-bandes, dans lequel certaines au moins des sous-bandes font l'objet d'une allocation dynamique de bits faisant varier le nombre de bits d'indices associés à des vecteurs de paramètres sélectionnés relativement à ces sous-bandes.

4. Procédé de codage selon l'une quelconque des revendications 1 à 3, dans lequel, pour au moins une valeur de débit correspondant à une valeur de l'entier *p*>0, le dictionnaire de référence est ordonné de façon à vérifier un critère de distances minimales entre les vecteurs appartenant à chaque groupe de 2^{*p*} vecteurs du dictionnaire de référence dont les adresses respectives ne diffèrent que par les *p* bits ayant lesdites positions prédéterminées.

5. Procédé de codage selon la revendication 4, dans lequel, pour ladite valeur de l'entier *p*>0, le vecteur de paramètres de codage est sélectionné dans un sous-dictionnaire de 2^{*Q-p*} vecteurs inclus dans le dictionnaire de référence, et dans lequel les *Q-p* bits de l'indice, complétés par *p* bits de positions et de valeurs prédéterminées, représentent l'adresse du vecteur sélectionné dans le dictionnaire de référence.

6. Procédé de codage selon l'une quelconque des revendications 1 à 3, dans lequel on consulte une table de transcodage (41) sur la base de l'adresse du vecteur sélectionné dans le dictionnaire de référence pour obtenir un premier indice de *Q* bits, et dans lequel, pour chaque valeur de débit correspondant à une valeur de l'entier *p*≥0, l'indice contenu dans le flux binaire de sortie (Φ) est formé de *Q-p* bits extraits dudit premier indice de *Q* bits en excluant p bits de positions prédéterminées.

7. Procédé de codage selon la revendication 6, comprenant un premier mode de fonctionnement dans lequel, pour chaque valeur de débit correspondant à une valeur de l'entier *p*≥0, l'indice contenu dans le flux binaire de sortie (Φ) est formé des *Q-p* bits extraits dudit premier indice de *Q* bits, et un second mode de fonctionnement à débit défini dans lequel l'adresse du vecteur sélectionné dans le dictionnaire de référence est incluse dans le flux binaire de sortie au lieu dudit indice de formé *Q-p* bits.

8. Procédé de codage selon la revendication 7, dans lequel, pour au moins une valeur de débit correspondant à une valeur de l'entier *p*>0 dans le premier mode de fonctionnement, on inclut dans le flux binaire de sortie (Φ) un nombre *p*', au plus égal à *p*, de bits d'information supplémentaire remplaçant *p*' des *p* bits exclus dudit premier indice de *Q* bits.

9. Procédé de codage selon l'une quelconque des revendications 6 à 8, dans lequel, pour au moins une valeur de débit correspondant à une valeur de l'entier *p*>0, la table de transcodage (41) est organisée de façon à vérifier un critère de distances minimales entre les vecteurs appartenant à chaque groupe de 2^{*p*} vecteurs du dictionnaire de référence dont les adresses respectives correspondent, par la table de transcodage, à des premiers indices de *Q* bits qui ne diffèrent que par les *p* bits ayant lesdites positions prédéterminées.

10. Codeur comprenant des moyens de traitement de signal mettant en oeuvre un procédé de codage selon l'une quelconque des revendications 1 à 9.

11. Procédé de décodage d'un flux binaire (Φ) représentatif d'un signal codé, le flux binaire contenant, pour une portion du signal, au moins un indice permettant d'obtenir, au moyen d'un dictionnaire de référence contenant 2^{*Q*} vecteurs désignés chacun par une adresse de *Q* bits, un vecteur de paramètres de codage utilisé pour construire une version décodée (S") de ladite portion de signal, caractérisé en ce que le débit du flux binaire dépend du nombre *Q-p* de bits formant ledit indice, et en ce que, pour chaque valeur de débit correspondant à une valeur de l'entier *p*>0, on obtient le vecteur de paramètres de codage à partir d'au moins un vecteur du dictionnaire de référence dont l'adresse appartient à un groupe de 2^{*p*} adresses respectivement représentées par des indices de *Q* bits formés en complétant par *p* bits arbitraires de positions prédéterminées l'indice de *Q-p* bits contenu dans le flux binaire.

12. Procédé de décodage selon la revendication 11, dans lequel le nombre *Q-p* de bits formant ledit indice est déterminé d'après une information lue dans le flux binaire.

13. Procédé de décodage selon la revendication 11 ou 12, comprenant un mode de fonctionnement par sélection de vecteur dans lequel, pour au moins une valeur de débit correspondant à une valeur de l'entier *p*>0, on obtient le vecteur de paramètres de codage en sélectionnant dans le dictionnaire de référence un vecteur dont l'adresse appartient audit groupe de 2^{*p*} adresses.

14. Procédé de décodage selon la revendication 13, comprenant une version du mode de fonctionnement par sélection de vecteur dans laquelle les *p* bits complétant les *Q-p* bits de l'indice contenu dans le flux binaire (Φ) pour représenter l'adresse du vecteur sélectionné sont des bits de valeurs prédéterminées.

15. Procédé de décodage selon la revendication 13 ou 14, comprenant une version du mode de fonctionnement par sélection de vecteur dans laquelle les *p* bits complétant les *Q-p* bits de l'indice contenu dans le flux binaire (Φ) pour représenter l'adresse du vecteur sélectionné sont tirés au hasard.

16. Procédé de décodage selon l'une quelconque des revendications 13 à 15, comprenant une version du mode de fonctionnement par sélection de vecteur dans laquelle on obtient le vecteur de paramètres de codage en le sélectionnant, parmi les vecteurs du dictionnaire de référence dont les adresses respectives appartiennent audit groupe de 2^{*p*} adresses, sur la base d'une information sur le signal codé.

17. Procédé de décodage selon la revendication 16, dans lequel ladite information sur le signal codé est lue dans le flux binaire (Φ).

18. Procédé de décodage selon la revendication 16, dans lequel ladite information sur le signal codé est obtenue par une analyse de la version décodée du signal.

19. Procédé de décodage selon la revendication 18, dans lequel ladite analyse comporte une prédiction du vecteur de paramètres de codage sur la base des vecteurs de paramètres obtenus pour des portions précédentes du signal, et dans lequel le vecteur sélectionné présente une similitude maximale avec le vecteur prédit parmi les vecteurs du dictionnaire de référence dont les adresses respectives appartiennent audit groupe de 2^{*p*} adresses.

20. Procédé de décodage selon l'une quelconque des revendications 11 à 19, comprenant un mode de fonctionnement par moyennage de vecteurs dans lequel, pour au moins une valeur de débit correspondant à une valeur de l'entier *p*>0, on obtient le vecteur de paramètres de codage en faisant une moyenne de plusieurs vecteurs du dictionnaire de référence dont les adresses respectives appartiennent audit groupe de 2^{*p*} adresses.

21. Procédé de décodage selon la revendication 20, comprenant une version du mode de fonctionnement par moyennage de vecteurs dans laquelle la moyenne faite pour obtenir le vecteur de paramètres de codage est une moyenne uniforme des vecteurs du dictionnaire de référence dont les adresses respectives appartiennent audit groupe de 2^{*p*} adresses.

22. Procédé de décodage selon la revendication 20 ou 21, comprenant une version du mode de fonctionnement par moyennage de vecteurs dans laquelle la moyenne faite pour obtenir le vecteur de paramètres de codage est une moyenne pondérée des vecteurs du dictionnaire de référence dont les adresses respectives appartiennent audit groupe de 2^{*p*} adresses, affectés de poids respectifs.

23. Procédé de décodage selon la revendication 22, dans lequel lesdits poids sont des coefficients fixes affectés aux vecteurs du dictionnaire de référence de façon représentative de leurs probabilités d'occurrence a priori.

24. Procédé de décodage selon la revendication 22, dans lequel lesdits poids sont des coefficients déterminés sur la base d'une information sur le signal codé.

25. Procédé de décodage selon la revendication 24, dans lequel ladite information sur le signal codé est lue dans le flux binaire (Φ).

26. Procédé de décodage selon la revendication 24, dans lequel ladite information sur le signal codé est obtenue par une analyse de la version décodée du signal.

27. Procédé de décodage selon la revendication 26, dans lequel ladite analyse se rapporte à un degré de stationnarité du signal.

28. Procédé de décodage selon la revendication 26, dans lequel ladite analyse comporte une prédiction du vecteur de paramètres de codage sur la base des vecteurs de paramètres obtenus pour des portions précédentes du signal, et dans lequel on affecte un poids maximal au vecteur qui, parmi les vecteurs du dictionnaire de référence dont les adresses respectives appartiennent audit groupe de 2^{*p*} adresses, présente une similitude maximale avec le vecteur prédit.

29. Procédé de décodage selon l'une quelconque des revendications 11 à 28, dans lequel on consulte une table de transcodage (43) sur la base d'au moins un desdits indices de *Q* bits formés en complétant l'indice de *Q-p* bits contenu dans le flux binaire (Φ) pour obtenir au moins une des 2^{*p*} adresses dudit groupe.

30. Procédé de décodage selon la revendication 29, comprenant un premier mode de fonctionnement dans lequel, pour chaque valeur de débit correspondant à une valeur de l'entier *p*≥0, le vecteur de paramètres de codage est obtenu à partir d'au moins un vecteur du dictionnaire de référence dont l'adresse est obtenue en consultant la table de transcodage (43), et un second mode de fonctionnement à débit défini dans lequel l'indice contenu dans le flux binaire (Φ) est de *Q* bits et le vecteur de paramètres de codage est obtenu comme étant le vecteur d'adresse égale audit indice de *Q* bits dans le dictionnaire de référence.

31. Procédé de décodage selon la revendication 30, dans lequel, pour au moins une valeur de débit correspondant à une valeur de l'entier *p*>0 dans le premier mode de fonctionnement, on reçoit *p* bits d'information supplémentaire dans le flux binaire (Φ).

32. Décodeur comprenant des moyens de traitement de signal mettant en oeuvre un procédé de décodage selon l'une quelconque des revendications 11 à31.

33. Procédé de transcodage d'un flux binaire d'entrée (Φ) représentatif d'un signal codé au moyen d'au moins un dictionnaire de référence contenant 2^{*Q*} vecteurs de paramètres de codage désignés chacun par une adresse de *Q* bits, pour former un flux binaire de sortie (Φ') de débit plus faible,
dans lequel le flux binaire d'entrée (Φ) contient, pour une portion du signal, au moins un indice de *Q* bits qui est égal à l'adresse dans le dictionnaire de référence d'un vecteur de paramètres de codage sélectionné,
dans lequel on consulte une table de transcodage (41) sur la base de ladite adresse du vecteur sélectionné pour obtenir un autre indice de *Q* bits,
et dans lequel, dans le flux de sortie, on remplace l'indice de *Q* bits contenu dans le flux d'entrée (Φ) par un indice traduit de *Q-p* bits qui, complétés par *p* bits arbitraires de positions prédéterminées, définissent des indices de *Q* bits représentant un groupe de 2^{*p*} adresses incluant ladite adresse du vecteur sélectionné, *p* étant un entier tel que 0<*p*<*Q*, ledit indice traduit de *Q-p* bits étant formé de *Q-p* bits extraits dudit autre indice de *Q* bits en excluant *p* bits de positions prédéterminées.

34. Procédé de transcodage selon la revendication 33, dans lequel on inclut dans le flux binaire de sortie (Φ') une information représentative du nombre *Q-p* de bits formant l'indice traduit.

35. Procédé de transcodage selon la revendication 33 ou 34, dans lequel le flux binaire d'entrée (Φ) est lu dans une mémoire d'un serveur audio.

36. Procédé de transcodage selon la revendication 33 ou 34, dans lequel le flux binaire d'entrée (Φ) est reçu sur une liaison d'un réseau de télécommunications et le flux binaire de sortie (Φ') est réémis sur une autre liaison du réseau ou sur une liaison d'un autre réseau.

37. Procédé de transcodage selon l'une quelconque des revendications 33 à 36, dans lequel le signal codé est un signal audio (S), dans lequel le flux binaire d'entrée (Φ) inclut des jeux d'indices de quantification associés à un ensemble de composantes spectrales respectives, chaque jeu d'indices associé à une composante de l'ensemble comportant au moins un indice traduisible par réduction de son nombre de bits et permettant de retrouver un vecteur de paramètres de codage.

38. Procédé de transcodage selon la revendication 37, dans lequel la ou les composantes spectrales associées aux jeux d'indices de quantification comportant un indice remplacé par un indice traduit dans le flux de sortie (Φ') sont choisies selon l'origine du signal audio codé.

39. Procédé de transcodage selon la revendication 37, dans lequel la ou les composantes spectrales associées aux jeux d'indices de quantification comportant un indice remplacé par un indice traduit dans le flux de sortie (Φ') sont choisies selon des caractéristiques d'un décodeur auquel est destiné le flux binaire de sortie.

40. Procédé de transcodage selon la revendication 37, dans lequel on analyse le flux binaire d'entrée (Φ) pour sélectionner, dans l'ensemble de composantes spectrales, au moins une composante d'énergie minimale, et dans lequel on remplace un indice du jeu d'indices de quantification associé à chaque composante sélectionnée par un indice traduit.

41. Procédé de transcodage selon la revendication 40, dans lequel le signal audio (S) est codé par fenêtres temporelles successives qui se composent chacune d'un ou plusieurs segments temporels successifs, chaque segment temporel d'une composante spectrale étant obtenu par le produit d'une forme d'onde appartenant à un dictionnaire et d'un gain, chaque jeu d'indices de quantification associé à une composante de l'ensemble comprenant des indices *(IF)* identifiant les formes d'onde et des indices (*GG, GR,* σ) identifiant les gains correspondants, et dans lequel l'analyse du flux binaire d'entrée (Φ) porte sur les indices de gains relatifs aux composantes de l'ensemble, la ou les composantes pour lesquelles les gains identifiés par ces indices sont les plus faibles étant sélectionnées.

42. Procédé de transcodage selon la revendication 41, dans lequel les indices *(IF)* identifiant les formes d'onde pour les composantes de l'ensemble sont des indices traduisibles.

43. Procédé de transcodage selon l'une des revendications 33 à 42, dans lequel on inclut dans le flux binaire de sortie (Φ') un nombre *p*', au plus égal à *p*, de bits d'information supplémentaire remplaçant *p*' des *p* bits exclus dudit autre indice de *Q* bits.

44. Procédé de transcodage selon l'une quelconque des revendications 33 à 43, dans lequel la table de transcodage (41) est organisée de façon à vérifier un critère de distances minimales entre les vecteurs appartenant à chaque groupe de 2^{*p*} vecteurs du dictionnaire de référence dont les adresses respectives correspondent, par la table de transcodage, à des indices de *Q* bits qui ne diffèrent que par les *p* bits ayant lesdites positions prédéterminées.

45. Procédé de transcodage d'un flux binaire d'entrée (Φ') représentatif d'un signal (S) codé au moyen d'au moins un dictionnaire de référence contenant 2^{*Q*} vecteurs désignés chacun par une adresse de *Q* bits, pour former un flux binaire de sortie (Φ") de débit plus élevé,
dans lequel le flux binaire d'entrée contient, pour une portion du signal, au moins un indice de *Q-p* bits qui, complétés par *p* bits arbitraires de positions prédéterminées, définissent des indices de *Q* bits représentant un groupe de 2^{*p*} adresses de vecteurs dans le dictionnaire de référence, *p* étant un entier tel que 0<*p*<*Q*,
et dans lequel on détermine, à partir dudit l'indice de *Q-p* bits, un indice traduit de *Q* bits représentant l'une des adresses dudit groupe de 2^{*p*} adresses de vecteurs, et on insère cet indice traduit de *Q* bits dans le flux de sortie.

46. Procédé de transcodage selon la revendication 45, dans lequel ledit indice traduit de *Q* bits est égal à l'une des adresses dudit groupe de 2^{*p*} adresses de vecteurs.

47. Procédé de transcodage selon la revendication 46, dans lequel on consulte une table de transcodage (43) sur la base d'au moins un indice de *Q* bits formé en complétant l'indice de *Q-p* bits contenu dans le flux binaire (Φ') par *p* bits auxdites positions prédéterminées, pour obtenir au moins une des 2^{*p*} adresses dudit groupe.

48. Procédé de transcodage selon l'une quelconque des revendications 45 à 47, comprenant un mode de fonctionnement dans lequel on complète les *Q-p* bits de l'indice contenu dans le flux binaire d'entrée (Φ') par *p* bits de valeurs prédéterminées pour déterminer l'indice traduit de *Q* bits.

49. Procédé de transcodage selon l'une quelconque des revendications 45 à 48, comprenant un mode de fonctionnement dans lequel on complète les *Q*-p bits de l'indice contenu dans le flux binaire d'entrée (Φ') par *p* bits tirés au hasard pour déterminer l'indice traduit de *Q* bits.

50. Procédé de transcodage selon l'une quelconque des revendications 45 à 49, comprenant un mode de fonctionnement dans lequel on sélectionne un vecteur de paramètres de codage, parmi les vecteurs du dictionnaire de référence dont les adresses respectives appartiennent audit groupe de 2^{*p*} adresses, sur la base d'une information sur le signal codé, et on forme l'indice traduit de *Q* bits de façon qu'il représente l'adresse du vecteur sélectionné.

51. Procédé de transcodage selon la revendication 50, dans lequel ladite information sur le signal codé est lue dans le flux binaire d'entrée (Φ').

52. Procédé de transcodage selon la revendication 50, dans lequel on effectue une prédiction du vecteur de paramètres de codage sur la base des vecteurs de paramètres de codage sélectionnés pour des portions précédentes du signal, et dans lequel le vecteur sélectionné présente une similitude maximale avec le vecteur prédit parmi les vecteurs du dictionnaire de référence dont les adresses respectives appartiennent audit groupe de 2^{*p*} adresses.

53. Transcodeur comprenant des moyens de traitement de signal mettant en oeuvre un procédé de transcodage selon l'une quelconque des revendications 33 à 52.
